# EUROPEAN PATENT APPLICATION

(11) **EP 0 622 880 A2**
(43) Date of publication of application: **02.11.1994**
(21) Application number: 94302782.1
(22) Date of filing: 20.04.1994
(51) Int. Cl.: H01S 3/19, H01S 3/085, H01L 29/40, H01L 29/36, H01L 23/48

(54) **Heterointerface with reduced resistance**

(30) Priority: 30.04.1993 US 55602
(71) Applicant: AT&T Corp., New York, NY 10013-2412 (US)
(72) Inventor: Asom, Moses Terlumun, Trexlertown, Pennsylvania 18107 (US); Kojima, Keisuke, Allentown, Pennsylvania 18103 (US); Morgan, Robert Anthony, Topton, Pennsylvania 19562 (US)
(74) Representative: Watts, Christopher Malcolm Kelway, Dr.

(57) **Abstract**

A delta doped layer is used at a heterointerface semiconductor mirror in a vertical cavity laser to reduce the series resistance of the laser. The layer, in a preferred embodiment, is in the mirror having p-type conductivity, because of the greater resistance in the p-type region than in the n-type region.

## Description

### Technical Field

This invention relates to semiconductor devices having at least one highly doped region between dissimilar bandgap regions.

### Background of the Invention

Most semiconductor devices, for example, field effect and bipolar transistors, lasers, etc., must be electrically contacted. The electrical contact frequently requires ohmic or Schottky barrier contacts to particular portions of the device. In addition to the formation of the electrical contacts, minimization of power consumption by the devices is also invariably desirable. This is true of devices, such as semiconductor lasers, which produce light output in response to electrical current passing through the device. Optimum performance requires minimization of electrical resistance within the device. Minimization of the electrical power required for a given optical power output results in a more efficient device and fewer adverse effects caused by ohmic heating. However, obtaining desirable electrical characteristics is frequently complicated by the constraint that the device have the desired optical characteristics. Reduction of electrical resistance is frequently more difficult with compound semiconductors than with elemental semiconductors, for example, silicon, because of the presence of heterointerfaces and energy band discontinuities in the compound semiconductors. The compound semiconductors may be Group II-VI, Group III-V or Group IV compound semiconductors.

One type of device that exemplifies the problems associated with forming the electrical contact and reducing the electrical resistance is termed the vertical cavity surface emitting laser. Such lasers are attractive for diverse applications because they have a small area and beam divergence and can be produced with planar technology thereby avoiding cleaved mirrors. These lasers have a p-i-n structure and there are n- and p-type distributed mirrors on opposite sides of the active region. The mirrors in vertical cavity lasers may be formed by pairs of high and low refractive index semiconductor layers fabricated so that they form quarter wavelength layers. For example, the mirrors may be formed from AlGaAs with adjacent layers having different Al concentrations thereby producing the desired difference in refractive index. Of course, the different Al concentrations in the AlGaAs layers produce compound semiconductors with different bandgaps, i.e., there are heterointerfaces within the mirrors. However, if the layers are sufficiently thick so that tunneling currents through the bandgap discontinuities at the heterointerfaces are minimal, carrier flow through the mirrors is seriously impeded. This, unfortunately, increases the series resistance of the device and leads to increased heating. Poorer device performance and reliability are also likely to result.

Attempts have been made by the skilled artisan to reduces the resistance at the heterointerfaces. This has been done by changing the structure of the layers forming the mirrors. For example, selective doping within the mirror has been combined with compositional grading of the layers which effectively reduce the bandgap discontinuity. See, for example, *Electronics Letters, 28, pp. 385-387,* *1992,* and *27, pp. 1984-1985, 1991,* and *Applied Physics, 60, pp. 466468, 1992*, for descriptions of compositional grading and selective doping used to reduce the electrical resistance of the mirrors. Of course, reductions of the resistance at heterointerfaces in other devices is important.

Attempts have also been made to produce ohmic contacts between semiconductors and metals. See, for example, *United States Patents 4,772,934* and *4,780,748* issued on September 20, 1988 and October 25, 1978, respectively. The contacts taught by these patents use a delta doped layer and a thin semiconductor layer between the delta doped layer and the metal. The thin semiconductor layer has a thickness less than the electron tunneling distance thereby permitting electrical conduction by tunneling.

### Summary of the Invention

In one embodiment, a device having first and second semiconductor layers with first and second bandgaps, respectively and a heterointerface between the first and second layers, has the electrical resistance of the heterointerface reduced by a delta doped layer at the heterointerface. The conductivity type can be either n-type or p-type. The effect on resistance is typically greater in p-type semiconductors. The first and second layers form a pair of layers. In a particular preferred embodiment, the device has first and second semiconductor mirrors having first and second conductivity types, respectively; and an active region between said first and second mirrors. The mirrors have a plurality of pairs of layers having first and second compositions with first and second bandgaps and heterointerfaces, and at least one delta doped layer at an heterointerface in at least one of said mirrors. The delta doped layer reduces the series resistance of the device which is, for example, a vertical cavity surface emitting laser. The mirrors may be fabricated from materials selected from Group III-V, Group II-VI, or Group IV compound semiconductors or Group IV semiconductors. The delta doped layer is effective in reducing the resistance in either the mirror having p-type or n-type conductivity.

### Brief Description of the Drawing

FIG. 1 is a sectional view of a laser according to one embodiment of this invention; and
FIG. 2 plots the voltage and light output vertically in units of volts and milliwatts, respectively, versus the current horizontally in units of milliamperes for both a vertical cavity surface emitting laser according to this invention and a prior art laser.

For reasons of clarity, the elements of the laser depicted are not drawn to scale.

### Detailed Description

The invention will be described by reference to a particular embodiment which is a vertical cavity surface emitting laser. Variations of this embodiment and still other embodiments will be apparent to those skilled in the art.

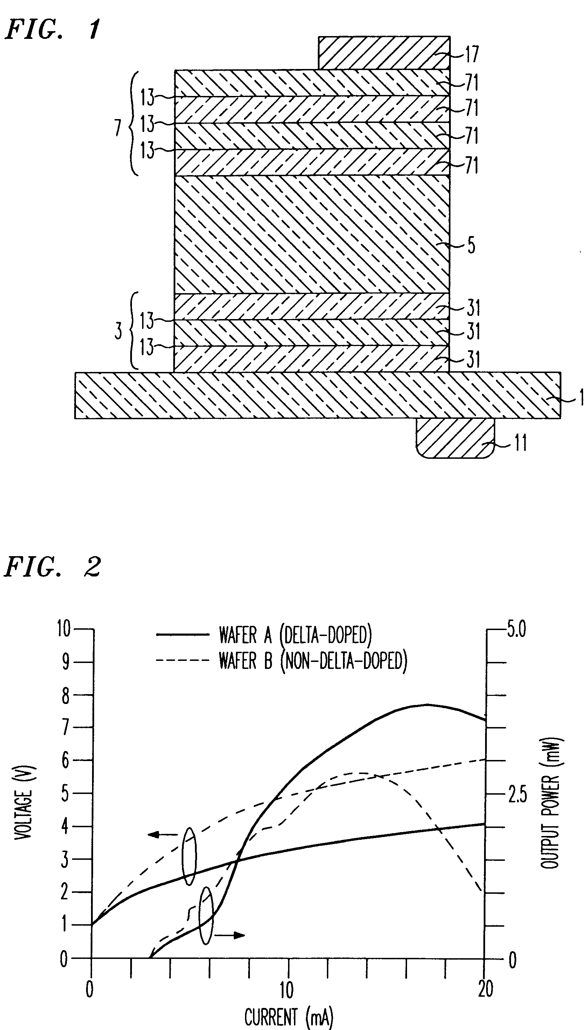

Depicted in FIG. 1 is a sectional view of a vertical cavity surface emitting laser having substrate 1, first mirror region 3, active region 5, and second mirror region 7. The mirror regions 3 and 7 typically have first and second conductivity types, respectively regions 3 and 7 each has a plurality of layers 31 and 71, respectively. There are also electrical contacts 11 and 17 to the laser. These contacts are to the substrate 1 and to the second mirror 7. There are also a plurality of highly doped regions 13 within the mirrors. These regions 13, which will be referred to as delta doped layers, are used to reduce the resistance of the laser; their structure and function will be discussed in more detail later. The contacts may have different configurations as is well known in the art. The materials, except for the contact, are conveniently selected from the group consisting of Group III-V and Group II-VI compound semiconductors. Group IV elemental and compound semiconductors may also be used. Individual compound semiconductors include AlGaAs, InAlAs, InGaAsP, etc. The contacts typically comprise a metal.

The mirrors have pluralities of semiconductor layers that are approximately a quarter wavelength thick or odd multiples thereof. The layers are arranged in pairs with the members of each pair having a different refractive index. The different refractive indices are obtained by use of different compositions in the two layers. For example, the mirrors may comprise pairs of alternating layers of Al_{y}Ga_{1-y}As and AlₓGa₁₋ₓAs with x and y selected so that the appropriate optical properties are obtained. For example x and y may be 0.16 and 0.58, respectively. Other values may, of course, be selected as may other materials. The first and second mirrors usually have first and second conductivity types, respectively. There is, of course, an interface between adjacent layers within the mirrors and between the mirrors and the active region. The delta doped layer is located at a heterointerface within a mirror, that is, at interface between layers 31 and layers 71. More than one delta doped layer may be present, and there may be delta doped layers in either or both of the mirrors. In the materials system described, the delta doped layer is more effective in the p-type layer because of the higher carrier mass.

The doped layers are relatively thin and may be called delta doped layers. Delta doping is a doping technique. In conventional doping using molecular beam epitaxy, the dopant is supplied to the substrate together with the, for example, Group III-V elements. In delta-doping, the crystal growth is interrupted by using a shutter to block the Group III-V beams and only the dopant beam is directed toward the substrate. Consequently, only a thin layer of the dopant is deposited on the surface of the substrate or crystal. Crystal growth is resumed by starting the Group III-V beams again. The dopant material may diffuse somewhat; a thin layer 5 to 10 nm thick is typically formed. A significant advantage of delta doping is that the dopant concentration may be locally higher than the solubility limit of the dopant. Another advantage is that the amount of the doping can be precisely controlled by stopping the growth rather than trying to adjust the temperature of the effusion cell; this is difficult to do in a reproducible manner. Hence, delta doping is a manufacturable technique for reducing the resistance of heterointerfaces. Suitable dopants for the n- and p-type mirror will be readily selected. For example, p-type dopants include Be, C, Mg, and Zn. The localized carrier density should be as high as is possible to obtain the maximum decrease in series resistance, yet suffer minimal effects of free carrier absorption.

The position of the delta doped layer must be carefully considered. A heavily doped layer increases the optical absorption locally. Accordingly, at the heterointerface where the optical field intensity is high, the delta doping may be lowered, and at the heterointerface where the optical field intensity is low, the concentration in the delta doped layer should be as high as is possible.

The semiconductor layers for the structure are conveniently grown by molecular beam epitaxy(MBE) which is a growth technique well known to those skilled in the art. The delta doped layer is grown as described. Other growth techniques, such as Metallic-Organic Chemical Vapor Deposition (MOCVD), may also be used. Conventional etching and metallization techniques may be used to complete device fabrication.

FIG. 2 plots the current horizontally in units of milliamps and both the light output, in units of milliwatts, and the voltage, in units of volts, vertically for a laser according to this invention with delta doped layers and a laser without the delta doped layers. The voltage and power output scales are shown on the left and right, respectively. The delta doped and non-delta doped lasers are shown by the solid and dashed lines, respectively. The p- mirror had 22.5 pairs of Al_{0.16}Ga_{0.84}As and AlAs with Al_{0.58}Ga_{0.42}As intermediate bandgap layers. The delta doping was done at the heterointerfaces. The emission window formed by the top metal contact was 10µm and the gain guide diameter was 20µm. The threshold currents are essentially identical although the threshold voltage for the delta doped structure is 2.3 volts rather than 3.3 volts. The differential resistance at threshold is 200 ohms for the delta doped laser and 360 ohms for the non-delta doped laser. The peak power was observed to increase and the threshold voltage to decrease for the delta doped laser as compared to the non-delta doped lasers. No significant difference in threshold current was observed for the two lasers. The intermediate bandgap layers are desirable, but may be omitted as previously described.

It will be appreciated that grading of the heterointerface is not required. This is desirable because it facilitates device manufacture; the delta doped layer is easier to produce and is more reproducible than is a graded layer. Additionally, the use of mechanical means, such as shutters to produce very short period superlattices, may significantly reduce the lifetime of the machine. This, of course, makes this technique less desirable for manufacture.

The reduction in resistance can be explained as follows. The hole current density J can be expressed as Jₚ=-qµₚp∇φₚ where µₚ is the hole mobility, p is the hole density, and φₚ is the quasi-Fermi level for holes. For the hole current density to be continuous, p must be very large to eliminate a steep variation of the quasi-Fermi level. If the hole density is very high at the interface due to delta-doping, then the voltage drop can be much smaller. Additionally, the excess free carrier absorption is minimal since the doping is done only locally.

Variations in the embodiment described will be readily thought of by those skilled in the art. For example, devices other than vertical cavity lasers may be fabricated. In general, any device having a heterointerface may use the delta doped layer at the heterointerface. It is to be understood that although the delta doped layers are described as being located at the heterointerface, some deviations from the interface will likely occur. The delta doped layer should be as close as possible to the heterointerface. Alternatives to the substrate contact also exist.

## Claims

1. A device comprising first and second layers (e.g., 3, 7) comprising semiconductors, said first and second layers (e.g., 3, 7) having first and second bandgaps and a heterointerface, and a delta doped layer (e.g., 13) at said heterointerface.

2. A device as recited in claim 1 in which said semiconductors have p-type conductivity.

3. A device as recited in claim 1 in which said semiconductors have n-type conductivity.

4. A device as recited in claim 1 in which said first and second layers (e.g., 3, 7) form a pair with each layer being approximately a quarter wavelength thick and having different refractive indices, thereby forming a mirror.

5. A device as recited in claim 4 comprising a plurality of said pairs formed by said first and second layers (e.g., 3, 7).

6. A device as recited in claim 4 further comprising an active region (e.g., 5), said active region (e.g., 5) being between adjacent pairs of said plurality, said pairs on opposite sides of said active region (e.g., 5) forming first and second mirrors (e.g., 3, 7).

7. A device recited in claim 6 in which said first and second mirrors (e.g., 3, 7) have a first and second conductivity type respectively.

8. A device as recited in claim 1 in which said semiconductors comprise compositions selected from the group consisting of Group III-V, Group II-V, and Group IV semiconductors.
